(19) Europäisches Patentamt

European Patent Office

Office européen des brevets

(11) **EP 1 205 032 B1**

(12) **FASCICULE DE BREVET EUROPEEN**

(45) Date de publication et mention
de la délivrance du brevet:
**29.09.2004 Bulletin 2004/40**

(21) Numéro de dépôt: **00953266.4**

(22) Date de dépôt: **19.07.2000**

(51) Int Cl.⁷: **H03M 13/27**, H03M 13/29
// H04L1:00

(86) Numéro de dépôt international:
**PCT/FR2000/002080**

(87) Numéro de publication internationale:
**WO 2001/006661 (25.01.2001 Gazette 2001/04)**

(54) **PROCEDE ET DISPOSITIF DE CODAGE A AU MOINS DEUX CODAGES EN PARALLELE ET PERMUTATION AMELIOREE, ET PROCEDE ET DISPOSITIF DE DECODAGE CORRESPONDANTS**

VERFAHREN UND VORRICHTUNG ZUR KODIERUNG MIT MINDESTENS ZWEI PARALLELEN KODIERERN

CODING METHOD AND DEVICE WITH AT LEAST TWO PARALLEL CODING STEPS AND IMPROVED PERMUTATION, AND CORRESPONDING DECODING METHOD AND DEVICE

(84) Etats contractants désignés:
**DE ES GB IT**

(30) Priorité: **21.07.1999 FR 9909631**

(43) Date de publication de la demande:
**15.05.2002 Bulletin 2002/20**

(73) Titulaires:
- **FRANCE TELECOM**
  **75015 Paris (FR)**
- **Groupe des Ecoles de Telecommunications-Etablissement ENST de Bretagne**
  **75634 Paris (FR)**

(72) Inventeurs:
- **BERROU, Claude**
  **F-29280 Locmaria Plouzane (FR)**
- **GLAVIEUX, Alain**
  **F-29280 Plouzane (FR)**

(74) Mandataire: **Bioret, Ludovic**
**Cabinet Vidon**
**16 B, rue Jouanet - B.P. 90333,**
**Technopole Atalante,**
**35703 Rennes Cedex 07 (FR)**

(56) Documents cités:
WO-A-99/07076   FR-A- 2 675 971
FR-A- 2 712 760   US-A- 4 394 642

- BERROU C ET AL: "NEAR OPTIMUM ERROR CORRECTING CODING AND DECODING: TURBO-CODES" IEEE TRANSACTIONS ON COMMUNICATIONS,US,IEEE INC. NEW YORK, vol. 44, no. 10, 1 octobre 1996 (1996-10-01), pages 1261-1271, XP000629465 ISSN: 0090-6778 cité dans la demande
- AITSAB O ET AL: "PERFORMANCE OF REED-SOLOMON BLOCK TURBO CODE" GLOBAL TELECOMMUNICATIONS CONFERENCE (GLOBECOM),US,NEW YORK, IEEE, 1996, pages 121-125, XP000742138 ISBN: 0-7803-3337-3 cité dans la demande
- BERROU C ET AL: "Non-binary convolutional codes for turbo coding" ELECTRONICS LETTERS, 7 JAN. 1999, IEE, UK, vol. 35, no. 1, pages 39-40, XP002138802 ISSN: 0013-5194 cité dans la demande

**Description**

Le domaine de l'invention est celui du codage de données numériques appartenant à une, ou plusieurs, séquences de données sources destinées à être transmises, ou diffusées, notamment en présence de bruits de transition, et du décodage des données codées ainsi transmises.

Plus précisément, l'invention concerne une amélioration du procédé de codage notamment connu sous ie nom de « turbo-codes » (marque déposée), et plus particulièrement de l'opération de permutation qu'il met en oeuvre.

Le principe général de ce type de codage est notamment présenté dans le brevet français n° FR-91 05280. ayant pour titre « Procédé de codage correcteur d'erreurs à au moins deux codages convolutifs systématiques parallèles, procédé de décodage itératif, module de décodage et décodeur correspondants », et dans l'article de C. Berrou et A. Glavieux « Near Optimum Error Correcting Coding and Decoding : Turbo Codes » (IEEE Transactions on Communications, Volume 44, n° 10, pages 1261-1271, Octobre 1996).

Selon cette technique. on propose la mise en oeuvre d'un codage à « concaténation parallèle », s'appuyant sur l'utilisation d'au moins deux codeurs élémentaires. Cela permet de disposer, lors du décodage, de deux symboles de redondance issus de deux codeurs distincts. Entre les deux codeurs élémentaires, on met en oeuvre des moyens de permutation, de façon que chacun de ces codeurs élémentaires soit alimenté par les mêmes données numériques source, mais prises dans des ordres différents.

Une amélioration à ce type de technique, destinée au codage en blocs (codes produits), est décrite dans le brevet FR-93 13858, et ayant pour titre « Turbo décodage des codes produits », ainsi que dans l'article de O. Aitsab et R. Pyndiah « Performance of Reed Solomon block turbo code » (IEEE Globecom 96 Conference, Vol. 1/3, pages 121-125, Londres, Novembre 1996).

Les performances des « turbo codes » convolutifs à concaténation parallèle dépendent, pour une part relativement importante, de la fonction de permutation mise en oeuvre. On constate en effet qu'un choix non optimisé de cette fonction peut conduire à une dégradation du « turbo code », avec notamment l'apparition d'un changement de pente de la courbe de taux d'erreurs en deçà de $10^{-5}$ et $10^{-6}$.

Ce phénomène est d'autant plus accentué que le rendement du « turbo codes » considéré est élevé, et que les blocs d'information à coder sont courts.

Dans les différents documents cités, des fonctions de permutation permettant de construire des « turbo codes » présentant de bonnes performances ont été proposées.

Dans le brevet FR-91 05280, les codes convolutifs élémentaires sont binaires, et les permutations ont donc lieu directement sur les éléments binaires. Plus généralement, de nombreuses solutions pour réaliser la fonction de permutation dans un « turbo code » à concaténation parallèle mettant en oeuvre des codes convolutifs binaires ont été proposées dans le cadre de la troisième génération de téléphones mobiles (UMTS).

Dans le brevet FR-93 13858, ainsi que dans l'article de C. Berrou et M. Jezequel « Non-binary convolutional codes for turbo coding », (Electronics Letters, Vol. 35, n° 1, pages 39-40, Janvier 1999), il est également proposé une utilisation de codes convolutifs non binaires pour construire des « turbo codes ». Dans ce cas, la fonction de permutation porte donc sur les mots binaires (ensembles de bits, par exemple couples, ou plus généralement n-couples).

D'une façon générale la fonction de permutation doit bien sûr permettre d'assurer une bonne dispersion des éléments issus de la source d'information et alimentant les différents codeurs parallèles, afin de créer un effet de désordre important. Il faut donc optimiser les propriétés de distance du codeur composite, et notamment maximiser sa distance minimale.

Ainsi, l'invention a notamment pour objectif de fournir un procédé de codage à concaténation parallèle (« turbo codes ») construits à partir de codes convolutifs non binaires et présentant des qualités de permutation meilleures que celles des « turbo codes » connus.

Plus précisément, un objectif de l'invention est de fournir un procédé de codage à concaténation parallèle optimisant les propriétés de distance du codeur composite (le « turbo code »), c'est-à-dire notamment de maximiser sa distance minimale.

Un autre objectif de l'invention est de fournir un tel procédé de codage, créant un effet de désordre important sur les données alimentant les différents codeurs élémentaires. bien sûr sans altérer l'effet de dispersion.

L'invention a également pour objectif de fournir un tel procédé de codage, qui puisse aisément être mis en oeuvre en pratique, de façon peu coûteuse, par exemple sous la forme d'un circuit intégré.

Encore un autre objectif de l'invention est de fournir un tel procédé de codage, qui puisse aisément être mis en oeuvre pour de très nombreux types d'applications.

Ces objectifs, ainsi que d'autres qui apparaîtront plus clairement par la suite, sont atteints selon l'invention à l'aide d'un procédé de codage de données numériques source, mettant en oeuvre en parallèle au moins deux étapes de codage élémentaire prenant chacune en compte l'ensemble desdites données source, et comprenant une étape de permutation modifiant l'ordre de prise en compte desdites données source entre lesdites étapes de codage élémentaire, dans lequel lesdites données source sont organisées en mots de code source comprenant chacun n éléments binaires source, n supérieur ou égal à 2. Selon l'invention, ladite étape de permutation comprend :

- une étape de modification réversible du contenu d'au moins certains desdits mots de code source, délivrant des mots de code modifiés ;
- une étape de permutation de l'ordre desdits mots de code source ou modifiés.

En d'autres termes, l'invention propose d'agir à un double niveau, lors de l'étape de permutation (on conserve ici le terme visuel de "permutation", mais les termes de "brassage", ou de "traitement" pourraient être avantageusement utilisés, car, comme on le verra par la suite, il est possible de modifier la valeur de certains éléments binaires). On agit en effet d'une part sur l'ordre des mots de code (ou n-uples), et d'autre part sur le contenu de ces derniers (modification intra-mots).

On notera que la permutation des mots peut aussi bien être effectuée avant ou après le traitement des mots de code eux-mêmes.

Selon un mode avantageux de réalisation, ladite étape de permutation de l'ordre des mots de code met en oeuvre une permutation uniforme appliquée sur un bloc de N mots de code consécutifs.

Cette technique est très simple à mettre en oeuvre, et permet d'atteindre une efficacité quasi optimale.

Elle peut avantageusement être mise en oeuvre à l'aide d' une mémoire contenant N mots de code introduits dans l'ordre 0 à N-1 et relue dans l'ordre j = P.i, i variant de 0 à N-1, P et N étant premiers entre eux.

Préférentiellement, dans ce cas, P est voisin de $\sqrt{N}$.

Selon une approche préférentielle de l'invention, que ladite modification du contenu n'est appliquée que sur certains desdits mots de code. Par exemple, ladite modification du contenu est appliquée à un mot de code sur deux.

Avantageusement, ladite modification du contenu comprend une permutation de l'ordre des éléments binaires à l'intérieur du mot de code considéré.

Selon un autre aspect avantageux, ladite modification du contenu comprend le remplacement d'au moins un des éléments binaires source du mot de code considéré par une combinaison d'au moins deux desdits éléments binaires source.

Lesdits mots de code peuvent notamment être des couples. Toutefois, bien sûr, il peut plus généralement s'agir de n-uples, quel que soit la valeur de n, supérieure ou égale à 2.

Dans le cas où il s'agit de couples, les combinaisons peuvent associer au couple source {a,b} au moins un des couples modifiés suivants :

- (a, b)
- (b, a)
- (a+b, b)
- (b, a+b)
- (a, a+b)
- (a+b, a)

Selon un mode de réalisation de l'invention, au moins une desdites étapes de codage élémentaires met en oeuvre un code convolutif, récursif et systématique de rendement naturel n/(n+m), associant à n entrées binaires n+m sorties binaires, avec n>2 et m>1.

Avantageusement, le procédé associe à un mot de code de n entrées binaires n + $m_1$ + $m_2$ sorties binaires comprenant :

- les n entrées binaires ;
- $m_1$ sorties binaires délivrées par une première étape de codage élémentaire ;
- $m_2$ sorties binaires délivrées par une seconde étape de codage élémentaire.

Une étape de poinçannage peut être prévue.

L'invention concerne également, bien sûr, les dispositifs de codage correspondant. Un tel dispositif met en oeuvre des moyens de permutation comprenant :

- des moyens de modification réversible du contenu d'au moins certains desdits mots de code source, délivrant des mots de code modifiés ;
- des moyens de permutation de l'ordre desdits mots de code, source ou modifiés.

L'invention concerne encore les dispositifs d'émission ou de transmission de données codées selon le procédé décrit ci-dessus.

Selon un autre aspect, l'invention concerne les procédés et dispositifs de décodage correspondants. Le procédé de décodage comprend, symétriquement au codage, les étapes de :

- modification du contenu d'au moins certains des mots de code reçus, ladite modification étant l'inverse de celle mise en oeuvre lors du codage ;
- permutation de l'ordre des mots de code reçus, de façon à remettre ces derniers dans l'ordre initial.

D'autres caractéristiques et avantages de l'invention apparaîtront plus clairement à la lecture de la description suivante d'un mode de réalisation préférentiel de l'invention, données à titre de simple exemple illustratif et non limitatif, et :

- de la figure unique annexée, qui illustre le principe général d'un codeur selon l'invention.

L'invention propose donc une nouvelle fonction de permutation pour codeur à concaténation parallèle de codes élémentaires, qui, associée à des codes élémentaires convolutifs, récursifs, systématiques, non binaires, de rendement naturel n/(n+m) avec $n \geq 2$ et $n \geq 1$, conduit à des performances proches de la limite théorique, et ceci quels que soient le rendement considéré pour le « turbo code » et la longueur des blocs d'informations à coder.

On rappelle que, dans le cadre de l'invention, les codes élémentaires considérés sont nécessairement non binaires, c'est-à-dire qu'ils présentent $n \geq 2$ entrées binaires et n+m, avec $m \geq 1$, sorties binaires.

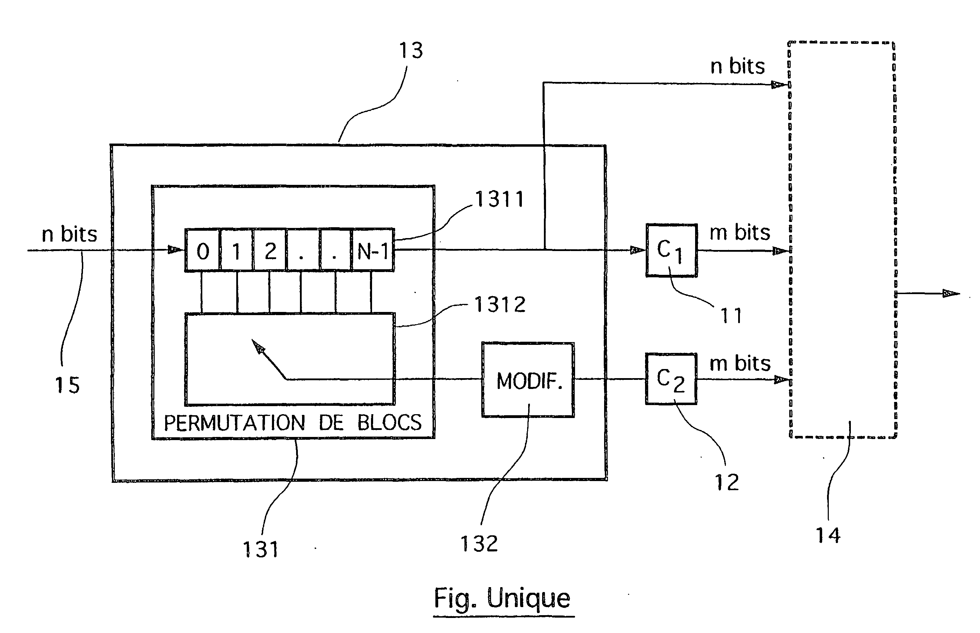

Un exemple de dispositif de codage selon l'invention est illustré en figure 1. Le procédé de codage correspondant s'en déduit directement.

Sur cet exemple, on considère un code construit à partir de la concaténation parallèle de deux codes élémentaires $C_1$ et $C_2$ 11 et 12, qui sont identiques, convolutifs, récursifs, systématiques, non binaires, de rendement 2/3 (n = 2 entrées binaires : les mots de code sont des couples) séparés par une fonction de permutation 13.

On suppose de plus que le bloc de données à coder est constitué de p données binaires, avec p pair ou, de manière équivalente, par N = p/2 couples binaires.

Si le codeur composite n'est pas poinçonné, son rendement de codage est alors égal 1/2. Bien sûr, un poinçonnage 14 peut être mis en oeuvre, de façon classique.

Comme déjà mentionné, selon l'invention, la fonction de permutation 13 repose sur une double opération :

- une permutation 131 de l'ordre des mots de code (dans l'exemple des couples, mais plus généralement tout n-uple) ;
- un traitement 132 sur au moins certains des blocs de données.

Les N couples issus de la source d'information 15 alimentent le codeur élémentaire $C_1$ puis, après permutation 13, le codeur $C_2$.

Une fonction de permutation doit permettre d'assurer une bonne dispersion des couples (plus généralement des n-uples) issus de la source d'information 15, et créer un effet de désordre important. Un des objectifs à atteindre est en effet d'optimiser les propriétés de distance du codeur composite et notamment de maximiser sa distance minimale.

Concernant le critère de dispersion, il s'agit de séparer le plus possible, après permutation 13, les couples adjacents (plus généralement les n-uples) en sortie de la source d'information 15. Cet objectif peut être atteint, de manière quasi optimale, en utilisant une permutation uniforme 131 au niveau des couples (plus généralement des n-uples).

Cette permutation uniforme 131 peut être réalisée en écrivant uniformément les N couples binaires (plus généralement les n-uples) dans une mémoire 1311 à N positions (positions 0 à N-1) et en venant lire (1312) ces N couples successivement aux adresses j, avec la règle suivante :

$$J=pi \text{ modulo } N \qquad i = 0,1...(N-1) \qquad (1)$$

Pour parcourir les N positions de la mémoire 1311 une fois et une seule, P et N doivent être deux nombres premiers entre eux (c'est-à-dire ne doivent pas avoir de diviseur commun sauf 1). De plus, pour assurer un espacement optimal entre les couples (plus généralement les n-uples) adjacents en sortie de la source 15, le paramètre P est préférentiellement voisin de $\sqrt{N}$.

Pour illustrer cet aspect, on considère, par exemple, un bloc de N = 9 couples binaires à coder. P est fixé à 4 (4 est voisin de $\sqrt{9} = 3$). On obtient alors :

| i | 0 | 1 | 2 | 3 | 4 | 5 | 6 | 7 | 8 |
|---|---|---|---|---|---|---|---|---|---|
| j | 0 | 4 | 8 | 3 | 7 | 2 | 6 | 1 | 5 |

Ainsi, les N couples à coder par le codeur $C_2$ sont respectivement lus aux adresses 0, 4, 8, 3, 7, 2, 6, 1, 5.

Pour créer l'effet de désordre, sans altérer l'effet de dispersion, on fait de plus subir aux données binaires de (au moins) certains couples (plus généralement de certains n-uples) un traitement 132, ou une modification appropriée.

Un traitement 132 simple et très efficace consiste à permuter les données binaires à l'intérieur d'un couple, de manière périodique, avant de présenter au codeur élémentaire $C_2$, par exemple selon la règle suivante :

soit $\{a_k, b_k\}$ le couple binaire mémorisé en position k, k = 0,1...(N-1) dans la mémoire. Pour les valeurs impaires de la variable i, les données binaires du couple lu à l'adresse j suivant la règle (I) sont permutées avant d'être présentées au codeur $C_2$.

En reprenant l'exemple précédent, les N = 9 couples à coder par le codeur $C_2$ sont alors présentés dans l'ordre suivant :

$\{a_0, b_0\}$, $\{\mathbf{b_4, a_4}\}$, $\{a_8, b_8\}$, $\{\mathbf{b_3, a_3}\}$, $\{a_7, b_7\}$, $\{\mathbf{b_2, a_2}\}$, $\{a_6, b_6\}$, $\{\mathbf{b_1, a_1}\}$, $\{a_5, b_5\}$

Les couples ayant subi une permutation ont été notés en gras.

D'autres opérations que la permutation des données binaires d'un couple sont bien sûr possibles, telles que par exemple :

$$\{a_k, b_k\} \Rightarrow \{a_k + b_k, b_k\} \text{ ou } \{a_k, b_k\} \Rightarrow \{b_k, a_k + b_k) \text{ modulo } 2$$

ou

$$\{a_k, b_k\} \Rightarrow \{a_k, a_k + b_k\} \text{ ou } \{a_k, b_k\} \Rightarrow \{a_k + b_k, a_k\} \text{ modulo } 2$$

Bien sûr, l'opération réalisée sur les données binaires de chaque couple est inversible. En effet, par exemple, connaissant $\{a_k + b_k, b_k\}$ on obtient $a_k$ en sommant les composantes $\{a_k + b_k\}$ et $\{b_k\}$.

Eventuellement, plusieurs opérations peuvent être cumulées et/ou utilisées alternativement.

Dans l'exemple illustré en figure 1, le traitement 132 des blocs de données est effectué après l'opération de permutation 131 de ces mêmes blocs. Il est clair cependant que l'ordre de ces opérations peut être inversé. Il est possible d'effectuer tout d'abord le traitement sur des mots de code (n-uples) puis leur permutation.

Ce procédé de permutation permet donc de construire des « turbo codes », à partir d'une concaténation parallèle de codes convolutifs, récursifs, systématiques de rendement naturel n/(n + m) ; n ≥ 2 ; m ≥ 1.

Les propriétés de distance, et notamment de distance minimale, de ces « turbo codes » sont supérieures à celles des « turbo codes » convolutifs connus. Ce résultat est d'autant plus marqué que le rendement de codage du « turbo code » est grand et que les blocs de données binaires à coder sont courts.

Cette fonction de permutation est donc particulièrement désignée pour construire des « turbo codes » convolutifs en blocs, pour le codage des transmissions où les données sont structurées par trames courtes (ATM par exemple).

Le décodage met en oeuvre les opérations inverses de celles mises en oeuvre lors du codage, à savoir :

- une modification du contenu des mots de code reçu (modification inverse), de façon à restituer les mots de code d'origine (hors perturbations dues au canal de transmission) ;
- une permutation de l'ordre des mots de code reçus, de façon à remettre ces derniers dans l'ordre initial.

Le principe général du décodage complet est avantageusement similaire à celui décrit dans le brevet FR - 91 05 280 déjà cité. Les informations élémentaires que s'échangent les décodeurs élémentaires (appelées informations extrinsèques) ne sont cependant plus, bien sûr, des valeurs binaires, mais des mots de code, ou n-uples.

L'information extrinsèque est donc portée par $2^n$ grandeurs, correspondant aux $2^n$ cas possibles pour les n-uples. Dans le cas de couples, tel que décrit précédemment, les décodeurs élémentaires s'échangent donc des données quatre par quatre.

**Revendications**

1. Procédé de codage de données numériques source, mettant en oeuvre en parallèle au moins deux étapes (11, 12) de codage élémentaire prenant chacune en compte l'ensemble desdites données source (15), et comprenant une étape de permutation (13) modifiant l'ordre de prise en compte desdites données source entre lesdites étapes (11, 12) de codage élémentaire, lesdites données source (15) étant organisées en mots de code source comprenant chacun n éléments binaires source, n supérieur ou égal à 2, **caractérisé en ce que** ladite étape de permutation (13) comprend :

   - une étape (132) de modification réversible du contenu d'au moins certains desdits mots de code source, délivrant des mots de code modifiés ;
   - une étape (131) de permutation de l'ordre desdits mots de code source ou modifiés.

2. Procédé de codage selon la revendication 1, **caractérisé en ce que** ladite étape (131) de permutation de l'ordre des mots de code met en oeuvre une permutation uniforme appliquée sur un bloc de N mots de code consécutifs.

3. Procédé de codage selon la revendication 2, **caractérisé en ce que** ladite permutation uniforme utilise une mémoire (1311) contenant N mots de code introduits dans l'ordre 0 à N-1 et relue dans l'ordre j = P.i, i variant de 0 à N-1, P et N étant premiers entre eux.

4. Procédé de codage selon la revendication 3, **caractérisé en ce que** P est voisin de $\sqrt{N}$.

5. Procédé de codage selon l'une quelconque des revendications 1 à 4, **caractérisé en ce que** ladite modification (132) du contenu n'est appliquée que sur certains desdits mots de code.

6. Procédé de codage selon la revendication 5, **caractérisé en ce que** ladite modification (132) du contenu est appliquée à un mot de code sur deux.

7. Procédé de codage selon l'une quelconque des revendications 1 à 6, **caractérisé en ce que** ladite modification (132) du contenu comprend une permutation de l'ordre des éléments binaires à l'intérieur du mot de code considéré.

8. Procédé de codage selon l'une quelconque des revendications 1 à 7, **caractérisé en ce que** ladite modification (132) du contenu comprend le remplacement d'au moins un des éléments binaires source du mot de code considéré par une combinaison d'au moins deux desdits éléments binaires source.

9. Procédé de codage selon l'une quelconque des revendications 1 à 8, **caractérisé en ce que** lesdits mots de code sont des couples d'éléments binaires.

10. Procédé de codage selon la revendication 9, **caractérisé en ce que** ladite étape de modification (132) du contenu associe au couple source {a,b} au moins un des couples modifiés suivants :

    - (a, b)
    - (b, a)
    - (a+b, b)
    - (b, a+b)
    - (a, a+b)
    - (a+b, a)

11. Procédé de codage selon l'une quelconque des revendications 1 à 10, **caractérisé en ce qu'**au moins une desdites étapes (11, 12) de codage élémentaire met en oeuvre un code convolutif, récursif et systématique de rendement naturel n/(n+m), associant à n entrées binaires n+m sorties binaires, avec n>2 et m>1.

12. Procédé de codage selon l'une quelconque des revendications 1 à 11, **caractérisé en ce qu'**il associe à un mot de code de n entrées binaires $n + m_1 + m_2$ sorties binaires comprenant :

    - les n entrées binaires ;
    - $m_1$ sorties binaires délivrées par une première étape de codage élémentaire ;
    - $m_2$ sorties binaires délivrées par une seconde étape de codage élémentaire.

**13.** Procédé de codage selon l'une quelconque des revendications 1 à 12, **caractérisé en ce qu'**il met en oeuvre une étape de poinçonnage (14).

**14.** Dispositif de codage de données numériques source comprenant au moins deux codeurs élémentaires (11, 12) prenant chacun en compte l'ensemble desdites données source (15), et des moyens de permutation (13) modifiant l'ordre de prise en compte desdites données source par chacun desdits codeurs élémentaires, lesdites données source étant organisées en mots de code source comprenant chacun n éléments binaires source, n supérieur ou égal à 2, **caractérisé en ce que** lesdits moyens de permutation (13) comprennent :

- des moyens (132) de modification réversible du contenu d'au moins certains desdits mots de code source, délivrant des mots de code modifiés ;
- des moyens (131) de permutation de l'ordre desdits mots de code, source ou modifiés.

**15.** Procédé de décodage de données numériques, organisées en mots de code, ledit procédé de décodage mettant en oeuvre au moins deux décodeurs élémentaires échangeant des mots de code, ledit procédé de décodage comprenant au moins une étape de permutation modifiant l'ordre de prise en compte desdits mots de code échangés par lesdits décodeurs élémentaires, lesdits mots de code étant organisés en n-uples, n étant supérieur ou égal à 2, **caractérisé en ce que** ladite au moins une étape de permutation comprend :

- une étape de modification réversible du contenu d'au moins certains desdits mots de code ; et
- une étape de permutation de l'ordre desdits mots de code ou modifiés.

**16.** Dispositif de décodage de données numériques, organisées en mots de code, ledit dispositif de décodage mettant en oeuvre au moins deux décodeurs élémentaires échangeant des mots de code et comprenant des moyens de permutation modifiant l'ordre de prise en compte desdits mots de code échangés par lesdits décodeurs élémentaires, lesdits mots de code étant organisés en n-uples, n étant supérieur ou égal à 2, **caractérisé en ce que** lesdits moyens de permutation comprennent :

- des moyens de modification réversible du contenu d'au moins certains desdits mots de code ; et
- des moyens de permutation de l'ordre desdits mots de code ou modifiés.

**17.** Dispositif d'émission de données numériques comprenant un dispositif de codage selon la revendication 14.

**18.** Système de codage/décodage de données numériques, **caractérisé en ce qu'**il comporte au moins un dispositif de codage selon la revendication 14 et au moins un dispositif de décodage selon la revendication 16.

**Patentansprüche**

**1.** Verfahren zum Codieren digitaler Quellendaten, bei dem mindestens zwei Schritte (11, 12) elementarer Codierung parallel zueinander eingesetzt werden, die jeweils die Gesamtheit der Quellendaten (15) berücksichtigen, und das einen Permutationsschritt (13) umfasst, der die Rangordnung der Berücksichtigung der Quellendaten zwischen den elementaren Codierungsschritten (11, 12) ändert, wobei die Quellendaten (15) als Quellenwortcodes organisiert sind, die jeweils n binäre Quellenelemente umfassen, wobei n größer oder gleich 2 ist, **dadurch gekennzeichnet, dass** der Permutationsschritt (13) folgendes umfasst:

- einen Schritt (132) zur reversiblen Änderung des Inhaltes von mindestens einigen der Quellencodewörter, der geänderte Codewörter liefert;
- einen Permutationsschritt (131) der Rangfolge der Quellencodewörter bzw. der geänderten Codewörter.

**2.** Codierungsverfahren nach Anspruch 1, **dadurch gekennzeichnet, dass** der Permutationsschritt (131) der Rangfolge der Codewörter eine gleichmäßige Permutation einsetzt, die auf einen Block von N aufeinander folgende Codewörter angewandt wird.

**3.** Codierungsverfahren nach Anspruch 2, **dadurch gekennzeichnet, dass** die gleichmäßige Permutation einen Speicher (1311) anwendet, der N Codewörter enthält, welche in der Reihenfolge 0 bis N-1 eingeführt und in der Reihenfolge j = P·i erneut gelesen werden, wobei i zwischen 0 und N-1 variiert und P und N untereinander Primzahlen sind.

**4.** Codierungsverfahren nach Anspruch 3, **dadurch gekennzeichnet, dass** P nahe bei √N liegt.

**5.** Codierungsverfahren nach einem der Ansprüche 1 bis 4, **dadurch gekennzeichnet, dass** die Änderung (132) des Inhaltes nur auf einige der Codewörter angewandt wird.

**6.** Codierungsverfahren nach Anspruch 5, **dadurch gekennzeichnet, dass** die Änderung (132) des Inhaltes auf jedem zweiten Codewort angewandt wird.

**7.** Codierungsverfahren nach einem der Ansprüche 1 bis 6, **dadurch gekennzeichnet, dass** die Änderung (132) des Inhaltes eine Permutation der Rangfolge der binären Elemente innerhalb des betrachteten Codeworts umfasst.

**8.** Codierungsverfahren nach einem der Ansprüche 1 bis 7, **dadurch gekennzeichnet, dass** die Änderung (132) des Inhaltes den Austausch von mindestens eines der binären Quellenelementen des betrachteten Codewortes gegen eine Kombination von mindestens zwei der besagten binären Quellenelemente umfasst.

**9.** Codierungsverfahren nach einem der Ansprüche 1 bis 8, **dadurch gekennzeichnet, dass** die Codewörter Paare binärer Elemente sind.

**10.** Codierungsverfahren nach Anspruch 9, **dadurch gekennzeichnet, dass** der Änderungsschritt (132) des Inhaltes dem Quellenpaar {a, b} mindestens eines der nachfolgenden geänderten Paare zuordnet:

- (a, b)
- (b, a)
- (a+b, b)
- (b, a+b)
- (a, a+b)
- (a+b, a)

**11.** Codierungsverfahren nach einem der Ansprüche 1 bis 10, **dadurch gekennzeichnet, dass** mindestens einer der elementaren Codierungsschritte (11, 12) einen rekursiven und systematischen Faltungscode mit natürlicher Leistung bzw. Coderate n/(n+m) einsetzt, der n binären Eingängen n+m binäre Ausgänge mit n>2 und m>1 zuordnet.

**12.** Codierungsverfahren nach einem der Ansprüche 1 bis 11, **dadurch gekennzeichnet, dass** es einem Codewort von n Binäreingängen, $n + m_1 + m_2$ Binärausgänge zuordnet, die folgendes umfassen:

- die n binären Eingänge;
- $m_1$ Binärausgänge, die von einem ersten elementaren Codierungsschritt geliefert werden;
- $m_2$ Binärausgänge, die von einem zweiten elementaren Codierungsschritt geliefert werden.

**13.** Codierungsverfahren nach einem der Ansprüche 1 bis 12, **dadurch gekennzeichnet, dass** es einen Markierungsschritt (14) anwendet.

**14.** Vorrichtung zum Codieren von digitalen Quellendaten, die mindestens zwei Elementarcodierer (11, 12) umfasst, die jeweils die Gesamtheit der Quellendaten (15) berücksichtigen sowie Permutationsmittel (13), welche die Reihenfolge der Berücksichtigung der Quellendaten durch einen jeden der Elementarcodierer ändert, wobei die Quellendaten als Quellencodewörter organisiert sind, die jeweils n binäre Quellenelemente umfassen, mit n größer oder gleich 2, **dadurch gekennzeichnet, dass** die Permutationselemente (13) folgendes umfassen:

- reversible Änderungsmittel (132) des Inhaltes von mindestens einigen der Quellenwörter, welche geänderte Codewörter liefern;
- Permutationsmittel (131) der Reihenfolge der Quellencodewörter oder der geänderten Codewörter.

**15.** Verfahren zum Decodieren von digitalen Daten, die als Codewörter organisiert sind, wobei das Decodierverfahren mindestens zwei elementare Decoder einsetzt, welche Codewörter untereinander austauschen, wobei das Decodierverfahren mindestens einen Permutationsschritt umfasst, der die Reihenfolge der Berücksichtigung der unter den elementaren Decoder ausgetauschten Codewörter umfasst,
wobei die besagten Codewörter als n-Fache organisiert sind, mit n größer oder gleich 2, **dadurch gekennzeichnet, dass** der mindestens eine Permutationsschritt folgendes umfasst:

- einen umkehrbaren Änderungsschritt des Inhaltes von mindesten einigen der Codewörter und,
- einen Schritt zur Permutation der Reihenfolge der Codewörter oder der geänderten Codewörter.

16. Verfahren zum Decodieren von digitalen Daten, die als Codewörter organisiert sind, wobei das Decodierverfahren mindestens zwei elementare Decoder einsetzt, welche Codewörter untereinander austauschen und Permutationsmittel umfassen, welche die Reihenfolge der Berücksichtigung der zwischen den elementaren Decodern ausgetauschten Codewörter ändern,
wobei die Codewörter als n-Fache organisiert sind, mit n größer oder gleich 2,
**dadurch gekennzeichnet, dass** die Permutationsmittel folgendes umfassen:

- umkehrbare Änderungsmittel des Inhaltes von mindestens einigen der Codewörter und,
- Permutationsmittel der Reihenfolge der Codewörter oder der geänderten Codewörter.

17. Vorrichtung zum Senden digitaler Daten, die eine Codiervorrichtung nach Anspruch 14 aufweist.

18. System zum Codieren/Decodieren von digitalen Daten, **dadurch gekennzeichnet, dass** es mindestens eine Codiervorrichtung nach Anspruch 14 und mindestens eine Decodiervorrichtung nach Anspruch 16 aufweist.

**Claims**

1. Scheme for coding digital source data, implementing in parallel at least two elementary coding steps (11, 12), each considering all of the said source data (15), and comprising a permutation step (13) modifying the sequence of consideration of the said source data between the said elementary coding steps (11, 12),
the said source data (15) being organized in source code words each comprising n binary source elements, n being greater than or equal to 2, **characterized in that** the said permutation step (13) comprises:

- a step (132) of reversibly modifying the content of at least some of the said source code words, delivering modified code words;

- a step (131) of permutating the sequence of the said source or modified code words.

2. Coding scheme according to Claim 1, **characterized in that** the said step (131) of permutating the sequence of the code words implements a uniform permutation applied to a block of N consecutive code words.

3. Coding scheme according to Claim 2, **characterized in that** the said uniform permutation uses a memory (1311) containing N code words entered in the sequence 0 to N-1 and reread in the sequence j = P.i, i varying from 0 to N-1, and P and N being mutually prime numbers.

4. Coding scheme according to Claim 3, **characterized in that** P is close to $\sqrt{N}$.

5. Coding scheme according to any one of Claims 1 to 4, **characterized in that** the said modification (132) of the content is applied only to some of the said code words.

6. Coding scheme according to Claim 5, **characterized in that** the said modification (132) of the content is applied to every other code word.

7. Coding scheme according to any one of Claims 1 to 6, **characterized in that** the said modification (132) of the content comprises a permutation of the sequence of the binary elements within the considered code word.

8. Coding scheme according to any one of Claims 1 to 7, **characterized in that** the said modification (132) of the content comprises the replacement of at least one of the binary source elements of the considered code word with a combination of at least two of the said binary source elements.

9. Coding scheme according to any one of Claims 1 to 8, **characterized in that** the said code words are pairs of binary elements.

10. Coding scheme according to Claim 9, **characterized in that** the said step (132) of modifying the content associates with the source pair {a, b} at least one of the following modified pairs:

   • (a, b)

   • (b, a)

   • (a+b, b)

   • (b, a+b)

   • (a, a+b)

   • (a+b, a)

11. Coding scheme according to any one of Claims 1 to 10, **characterized in that** at least one of the said elementary coding steps (11, 12) implements a systematic recursive convolutional code with natural output n/(n+m), associating n binary inputs with n+m binary outputs, with n > 2 and m > 1.

12. Coding scheme according to any one of Claims 1 to 11, **characterized in that** it associates with a code word of n binary inputs $n + m_1 + m_2$ binary outputs comprising:

   • the n binary inputs;

   • $m_1$ binary outputs delivered by a first elementary coding step;

   • $m_2$ binary outputs delivered by a second elementary coding step.

13. Coding scheme according to any one of Claims 1 to 12, **characterized in that** it implements a stamping step (14).

14. Device for coding digital source data, comprising at least two elementary encoders (11, 12), each considering all of the said source data (15), and permutation means (13) modifying the sequence of consideration of the said source data by each of the said elementary encoders,
   the said source data (15) being organized in source code words each comprising n binary source elements, n being greater than or equal to 2, **characterized in that** the said permutation means (13) comprise:

   - means (132) for reversibly modifying the content of at least some of the said source code words, delivering modified code words;

   - means (131) for permutating the sequence of the said source or modified code words.

15. Scheme for decoding digital data organized in code words, the said decoding scheme implementing at least two elementary decoders exchanging code words, the said decoding scheme comprising at least one permutation step modifying the sequence of consideration of the said code words exchanged by the said elementary decoders,
   the said code words being organized in n-uples, n being greater than or equal to 2, **characterized in that** the said at least one permutation step comprises:

   - a step of reversibly modifying the content of at least some of the said code words; and

   - a step of permutating the sequence of the said code words or modified words.

16. Device for decoding digital data organized in code words, the said decoding device implementing at least two elementary decoders exchanging code words and comprising permutation means modifying the sequence of consideration of the said code words exchanged by the said elementary decoders,
   the said code words being organized in n-uples, n being greater than or equal to 2, **characterized in that** the said permutation means comprise:

- means for reversibly modifying the content of at least some of the said code words; and

- means for permutating the sequence of the said code words or modified words.

17. Device for transmitting digital data, comprising an encoding device according to Claim 14.

18. System for coding/decoding digital data, **characterized in that** it comprises at least one coding device according to Claim 14 and at least one decoding device according to Claim 16.

13

n bits

1311

n bits

0 | 1 | 2 | . | . | N-1

1312

C₁ → m bits

11

PERMUTATION DE BLOCS

MODIF.

C₂ → m bits

15

131

132

12

14

Fig. Unique

EP 1 205 032 B1